(19) Europäisches Patentamt
European Patent Office
Office européen des brevets

(11) **EP 4 752 881 A2**

(12) **EUROPEAN PATENT APPLICATION**

(43) Date of publication:
**03.06.2026 Bulletin 2026/23**

(21) Application number: **25214088.4**

(22) Date of filing: **06.11.2025**

(51) International Patent Classification (IPC):
**G11C 5/02** (2006.01)   **G11C 5/04** (2006.01)
**H10W 70/60** (2026.01)   **H10W 90/00** (2026.01)

(52) Cooperative Patent Classification (CPC):
**G11C 5/025; G11C 5/04; H10W 70/611;
H10W 90/401**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **29.11.2024 KR 20240175632**

(71) Applicant: **Samsung Electronics Co., Ltd.
Suwon-si, Gyeonggi-do 16677 (KR)**

(72) Inventors:
• YUN, Seok Ju
  16678 Suwon-si (KR)
• KONG, Tae-Hwang
  16678 Suwon-si (KR)
• JUNG, Seungchul
  16678 Suwon-si (KR)
• CHOI, Hun Seong
  16678 Suwon-si (KR)

(74) Representative: **Arnold & Siedsma
Bezuidenhoutseweg 57
2594 AC The Hague (NL)**

(54) **ACTIVE INTERCONNECT DIE AND SEMICONDUCTOR PACKAGE INCLUDING THE SAME**

(57)    A semiconductor package includes an active interconnect die including a modulator and at least one first metal line, a processor die on the active interconnect die, first memory dies stacked on each other on the active interconnect die and spaced apart from the processor die by a first lateral distance, and second memory dies stacked on each other on the active interconnect die and spaced apart from the processor die by a second lateral distance that is greater than the first lateral distance, where the at least one first metal line is configured for data communication between the second memory dies and the processor die.

FIG. 1

**Description**

1. Field

The disclosure relates to an active interconnect die and a semiconductor package including the same.

2. Description of Related Art

A contemporary electronic device requires high performance and energy efficiency. To satisfy these requirements, a semiconductor integrated circuit (IC) technology has been continuously developed. Specifically, the rapid development of a high-performance computing device, an artificial intelligence (AI) processor, a graphics processing unit (GPU), a data center, and a mobile device requires faster processing speed and greater data processing capacity.
Multi-die or system-on-chip (SoC) technology may be implemented. The technology enables multiple processors, memories, and various functional blocks to be integrated into a single package to operate, contributing to improving spatial efficiency and performance. **In** a high-performance system, maintaining credibility while optimizing the data transmission speed between a processor and multiple memories is important and thus, a new packaging method and power management solution are required.
Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.
This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.
According to an aspect of the disclosure, a semiconductor package may include an active interconnect die including a modulator and at least one first metal line, a processor die on the active interconnect die, first memory dies stacked on each other on the active interconnect die and spaced apart from the processor die by a first lateral distance, and second memory dies stacked on each other on the active interconnect die and spaced apart from the processor die by a second lateral distance that is greater than the first lateral distance, where the at least one first metal line is configured for data communication between the second memory dies and the processor die.
The active interconnect die may include at least one second metal line configured for the data communication between the first memory dies and the processor die, and the at least one first metal line may be thicker than the at least one second metal line.
A symbol rate of the data communication between the second memory dies and the processor die may be greater than a symbol rate of the data communication between the first memory dies and the processor die.
A SerDes ratio of the data communication between the second memory dies and the processor die may be less than a SerDes ratio of the data communication between the first memory dies and the processor die.
The active interconnect die may include at least one second metal line configured for the data communication between the first memory dies and the processor die, and a number of the at least one first metal line may be different from a number of the at least one second metal line.
The processor die may include a plurality of pins, and a first number of pins of the plurality of pins of the processor die connected to the second memory dies may be greater than a second number of pins of the plurality of pins of the processor die connected to the first memory dies.
The first memory dies may be in a first high bandwidth memory (HBM) and the second memory dies may be in a second HBM, or the first memory dies and the second memory dies may be in a same HBM.
A modulation type of the data communication between the second memory dies and the processor die may be controlled based on a loss of a signal transmitted through the at least one first metal line from the second memory dies.
A signal gain of the data communication between the second memory dies and the processor die may be controlled based on a strength of a signal transmitted through the at least one first metal line from the second memory dies.
A frequency of a clock signal provided to a through silicon via (TSV) of at least one of the first memory dies and the second memory dies may be lower than a frequency of a clock signal provided to the modulator.
According to an aspect of the disclosure, an active interconnect die may include a serializer configured to convert parallel data received from memory dies stacked on the active interconnect die into serial data based on a SerDes ratio, a modulator configured to modulate the serial data and transmit the modulated serial data to at least one metal line, and three-dimensional input/output (3DIOs) configured to demodulate the modulated serial data received through the at least one metal line and transmit the demodulated serial data to a processor die on the active interconnect die.
At least one of the SerDes ratio or a modulation type of the serial data may be determined based on a lateral distance between the memory dies and the processor die.

At least one of a number of the at least one metal line or a thickness of the at least one metal line may be determined based on a lateral distance between the memory dies and the processor die.

The processor die may be a number of pins, and the number of pins of the processor die that are connected to the 3DIOs may be determined based on a lateral distance between the memory dies and the processor die.

The memory dies may be in a HBM.

A modulation type of the serial data may be controlled based on a loss of a signal received by the 3DIOs through the at least one metal line.

A signal gain transmitted through the at least one metal line may be controlled based on a strength of a signal received by the 3DIOs through the at least one metal line.

A frequency of a clock signal provided to a through silicon via (TSV) of the memory dies may be lower than a frequency of a clock signal of the modulator.

According to an aspect of the disclosure, a semiconductor package may include an interposer, a logic die on the interposer, the logic die including a modulator, memory dies stacked on the logic die and connected to the logic die via a through electrode, a processor die on the interposer, and a redistribution layer (RDL) below the interposer, the RDL including at least one metal line, where the modulator and the at least one metal line may be configured for data communication between the memory dies and the processor die.

The modulator may be configured to modulate data received from the memory dies, and the modulated data may be transmitted to the processor die by sequentially passing through the interposer, the at least one metal line in the RDL, and the interposer.

The above and other aspects, features, and advantages of certain embodiments of the disclosure will be more apparent from the following description taken in conjunction with the accompanying drawings, in which:

FIG. 1 is a diagram illustrating an arrangement of a processor die and a memory stack according to one or more embodiments.

FIG. 2 is a perspective view of a semiconductor package structure according to one or more embodiments.

FIG. 3 is a cross-sectional view of a semiconductor package illustrating data movement in a semiconductor package, according to one or more embodiments.

FIG. 4 is a conceptual view of a semiconductor package structure according to one or more embodiments.

FIG. 5 is a diagram illustrating operations of an active interconnect die included in a semiconductor package according to one or more embodiments.

FIG. 6 is a diagram illustrating a total data rate of short range memory dies and long range memory dies according to one or more embodiments.

FIG. 7 is a diagram illustrating adaptive control applied to a transceiver (TRX) according to one or more embodiments.

FIG. 8 is a diagram illustrating an active interconnect die of face-to-face connection according to one or more embodiments.

FIG. 9 is a diagram illustrating a semiconductor package structure to which a redistribution layer (RDL) is applied, according to one or more embodiments.

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, example embodiments will be described in detail with reference to the accompanying drawings. The embodiments described below are merely exemplary, and various modifications are possible from these embodiments.

Throughout the drawings and the detailed description, unless otherwise described or provided, the same drawing reference numerals will be understood to refer to the same elements, features, and structures. The drawings may not be to scale, and the relative size, proportions, and depiction of elements in the drawings may be exaggerated for clarity, illustration, and convenience.

Although terms, such as first, second, and the like are used to describe various components, the components are not limited to the terms. These terms should be used only to distinguish one component from another component. For example, a first component may be referred to as a second component, and similarly, the second component may also be referred to as the first component.

It should be noted that if it is described that one component is "connected", "coupled", or "joined" to another component, a third component may be "connected", "coupled", and "joined" between the first and second components, although the first component may be directly connected, coupled, or joined to the second component.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The singular forms "a", "an", and "the" include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

Unless otherwise defined, all terms, including technical and scientific terms, used herein have the same meaning as commonly understood by one of ordinary skill in the art to which the present disclosure pertains. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

Operations of a method may be performed in an appropriate order unless explicitly described in terms of order. In addition, the use of all illustrative terms (e.g., etc.) is merely for describing technical ideas in detail, and the scope is not limited by these examples or illustrative terms unless limited by the claims.

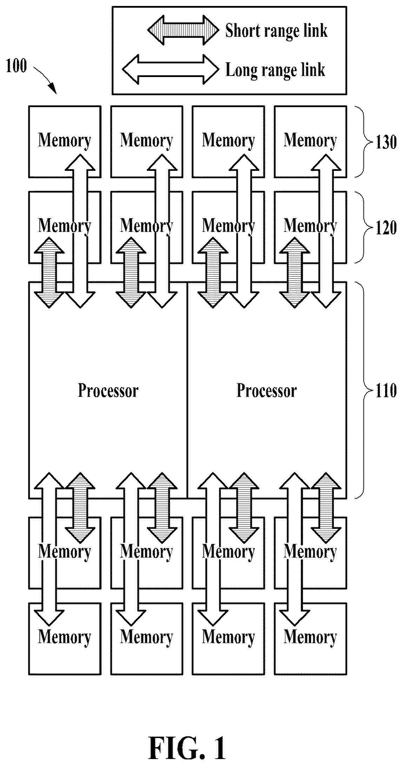

FIG. 1 is a diagram illustrating an arrangement of a processor die and a memory stack according to one or more embodiments.

Referring to FIG. 1, a semiconductor package 100 may include one or more processors 110 and a plurality of memories 120 and 130.

The one or more processors 110 may process data or perform given operations and/or tasks, and may include various processors, for example, a central processing unit (CPU), a graphics processing unit (GPU), a neural processing unit (NPU), a tensor processing unit (TPU), and a digital signal processor (DSP). Through this, a high-performance computational task, more particularly, a machine learning task such as artificial intelligence (AI) and a deep neural network (DNN), may be efficiently performed. A computing system including the semiconductor package 100 may perform various high-performance computational tasks including machine learning. The machine learning may be used in various application fields, such as data analysis, image processing, and natural language processing, including AI and a DNN.

The plurality of memories 120 and 130 may store data processed by the one or more processors 110 and may include, for example, a high bandwidth memory (HBM). Since transmitting a large volume of data processed by the one or more processors 110 at high speed from the plurality of memories 120 and 130 to the one or more processors 110 may have a significant impact on the performance of the semiconductor package 100, the plurality of memories 120 and 130 may be disposed adjacent to the one or more processors 110. Due to the physical size limitation, only near memories 120 of the plurality of memories 120 and 130 may be disposed near an edge of the processor and the far memories 130 may be disposed further from the processor compared to the near memories 120. That is, the memories 120 may be closer in proximity to the processors 110 than memories 130, such that the processors 110 are provided, memories 120 are adjacent to the processors 110, and the memories 130 are adjacent to the memories 120.

The far memories 130 may be used to connect more memories to a single processor for improved performance, but the expansion of the number of memories may be effective when a bandwidth and performance of the memory are maintained. In other words, maintaining the transmission rate and bandwidth between the far memories 130 and a processor at a predetermined level is important.

Hereinafter, a method of transmitting data at high speed to the processor from not only the near memories 120 but also the far memories 130 is further described with reference to drawings.

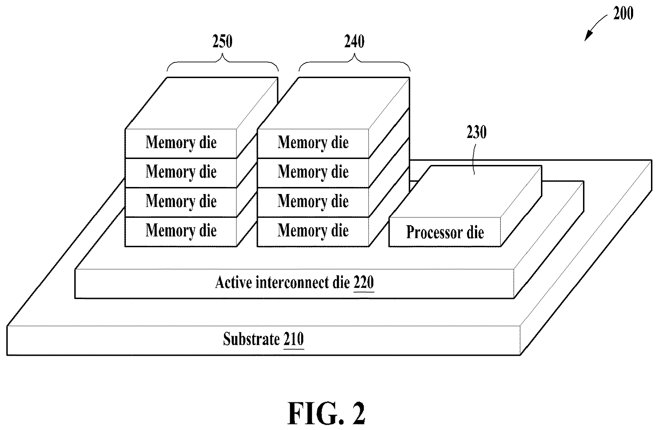

FIG. 2 is a perspective view of a semiconductor package structure according to one or more embodiments.

Referring to FIG. 2, a semiconductor package 200 may include a substrate 210, an active interconnect die 220, a processor die 230, first memory dies 240, and second memory dies 250. The active interconnect die 220 may be disposed on the substrate 210. The first memory dies 240, the second memory dies 250, and the processor die 230 may be disposed on the active interconnect die 220. Although FIG. 2 illustrates two stacks of memory dies and one processor die, embodiments are not limited thereto. The numbers of memory dies and processor dies disposed on the active interconnect die 220 are not limited thereto.

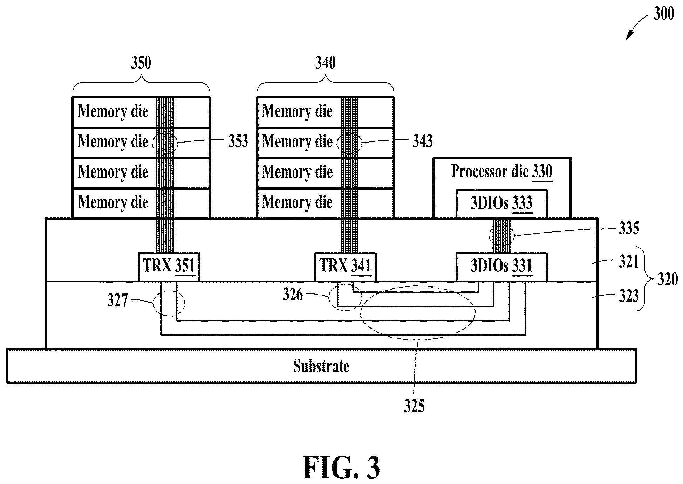

The active interconnect die 220 may be a layer providing an electrical connection between the processor die 230 and the first and second memory dies 240 and 250, and may include an active circuit. The processor die 230 may be spaced apart from the first memory dies 240 by a first lateral distance, and the processor die 230 may be spaced apart from the second memory dies 250 by a second lateral distance that is greater than the first lateral distance, such that the second memory dies 250 are further away from the processor die 230 than the first memory dies 240. The second memory dies 250 may be referred to as being "disposed far" or "far range" while the first memory dies 240 may be referred to as "disposed near" or "short range" relative to each other and the processor die 230. Data transfer between the processor die 230 and the second memory dies 250 disposed far may be rapidly performed through an active circuit included in the active interconnect die 220. The active interconnect die 220 may improve the performance of the second memory dies 250 while functioning as a logic die and a passive interposer included in a 2.5 high bandwidth memory (HBM) chiplet structure. The active interconnect die 220 may manage and optimize data transfer between the processor die 230 and the first and second memory dies 240 and 250. The active interconnect die 220 is further described with reference to FIGS. 3 to 8.

The processor die 230 may play a core role in processing data transmitted from the memory dies 240/250 and may include various processors, such as a CPU, a GPU, and an NPU. The processor die 230 may be designed to efficiently perform a high-performance computational task and may smoothly process data transfer with memory dies.

The first and second memory dies 240 and 250 may have a structure in which memory dies for storing data are stacked as multiple layers. For example, the first and second memory dies 240 and 250 may be implemented as separate HBMs and may provide high data transfer rates and bandwidths. However, the first and second memory dies 240 and 250 are not limited thereto. Each of the first and second memory dies 240 and 250 may be implemented as not only an HBM device but also a low power double data rate (LPDDR) device, a graphics double data rate (GDDR) device, or a double data rate (DDR) device. The first memory dies 240 may be short range memory dies disposed on the edge of the processor die 230 and the second memory dies 250 may be long range memory dies disposed relatively far from the processor die 230. The plurality of memory dies may be referred to as a memory stack.

The semiconductor package 200 may be a physical structure in which a semiconductor chip is attached to the substrate 210 and is connected to an external circuit. The semiconductor package 200 may be referred to as a semiconductor structure or a semiconductor device.

The semiconductor package 200 according to one or more embodiments may be advantageously used in an application field that requires high bandwidth data transmission. As shown in FIG. 2, when a plurality of memory stacks 240/250are connected to a single processor die 230, each memory stack may efficiently communicate with a processor die 230 through an active interconnect die 220. This may maximize the performance and scalability of the system and specifically, may provide a significant benefit to parallel data processing and high-performance computational tasks.

FIG. 3 is a cross-sectional view of a semiconductor package illustrating data movement in a semiconductor package, according to one or more embodiments.

Referring to FIG. 3, since the second memory dies 350 are disposed further away from a processor die 330 than the first memory dies 340 on an active interconnect die 320, an electrical loss may occur when transmitting a signal. To compensate for this, transceivers (TRX) 341 and 351 and active circuits, such as three-dimensional input/outputs (3DIOs) 331 may be included in the active interconnect die 320. For example, the 3DIOs 331 may have an array form including a plurality of 3DIOs. Hereinafter, data transfer between the processor die 330 and the first and second memory dies 340 and 350 is further described with reference to FIG. 3.

The first memory dies 340 and the active interconnect die 320 may be physically connected via a through electrode 343. The through electrode 343 may transmit an electrical signal by vertically penetrating the inside of the first memory dies 340, may transmit the data of the first memory dies 340 to the active interconnect die 320 or may efficiently transmit the data from the active interconnect die 320 to the first memory dies 340. By using the through electrode 343, a data line of the first memory dies 340 may extend to the active interconnect die 320 and may be connected to the active interconnect die 320. The through electrode 343 may be a through silicon via (TSV) that penetrates a silicon substrate. The TSV may provide a high-speed path for transmitting the data generated by the first memory dies 340 to the active interconnect die 320 rapidly without loss and may maintain signal integrity in the package. A plurality of data lines connecting the first memory dies 340 to the active interconnect die 320 may be formed through the TSV and parallel data may be rapidly transmitted through the plurality of data lines. Similarly, the second memory dies 350 and the active interconnect die 320 may be physically connected via a through electrode 353 to transmit data.

In the semiconductor package 300 that adopts the active interconnect die 320, the active interconnect die 320 includes an active circuit, and therefore, a PHY circuit that is conventionally implemented may no longer be required. This may allow the data line to be directly connected to the TRXs 341 and 351 of the active interconnect die 320, and thereby, a data transmission path may be simplified and signal delay and loss may be minimized. The data transmission rate and the system performance may be improved by directly connecting the data lines provided by the first and second memory dies 340 and 350 to the active interconnect die 320.

The active interconnect die 320 may include a silicon layer 321 and a metal layer 323. The silicon layer 321 may include the TRXs 341 and 351 and active circuits such as the 3DIOs 331. The metal layer 323 may include metal lines 325, including a first metal line 326 connecting the 3DIOs 331 to the TRX 341 and the first memory dies 340, and a second metal line 327 connecting the 3DIOs 331 to the TRX 351 and the second memory dies 350. The metal layer 323 may correspond to a back end of the line (BEOL) area.

Although described further below, the TRX 341 may convert parallel data received from the first memory dies 340 into serial data according to a SerDes ratio and may modulate the serial data and transmit the modulated serial data to the metal lines 326. Similarly, the TRX 351 may convert parallel data received from the second memory dies 350 into serial data according to a SerDes ratio and may modulate the serial data and transmit the modulated serial data to the metal lines 327. Since a metal channel loss may vary depending on a transmission distance, the SerDes ratios and/or modulation types applied to the TRXs 341 and 351 may be different from each other. In addition, the thicknesses and/or numbers of metal lines 325 connected to the TRXs 341 and 351 may be different from each other.

The 3DIOs 331 disposed under the processor die 330 may receive the modulated serial data transmitted through the metal lines 325. The 3DIOs 331 may demodulate the modulated serial data received through the metal lines 325 and may convert the demodulated serial data into parallel data. The 3DIOs 331 may transmit the parallel data to 3DIOs 333 in the processor die 330 through a through electrode 335.

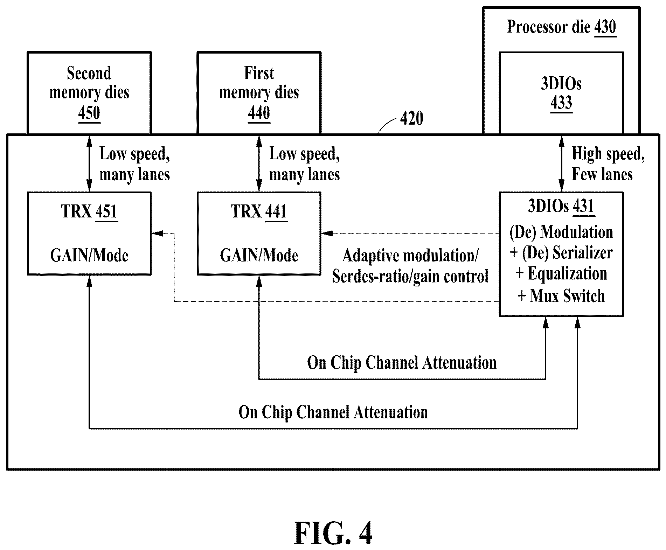

FIG. 4 is a conceptual view of a semiconductor package structure according to one or more embodiments.

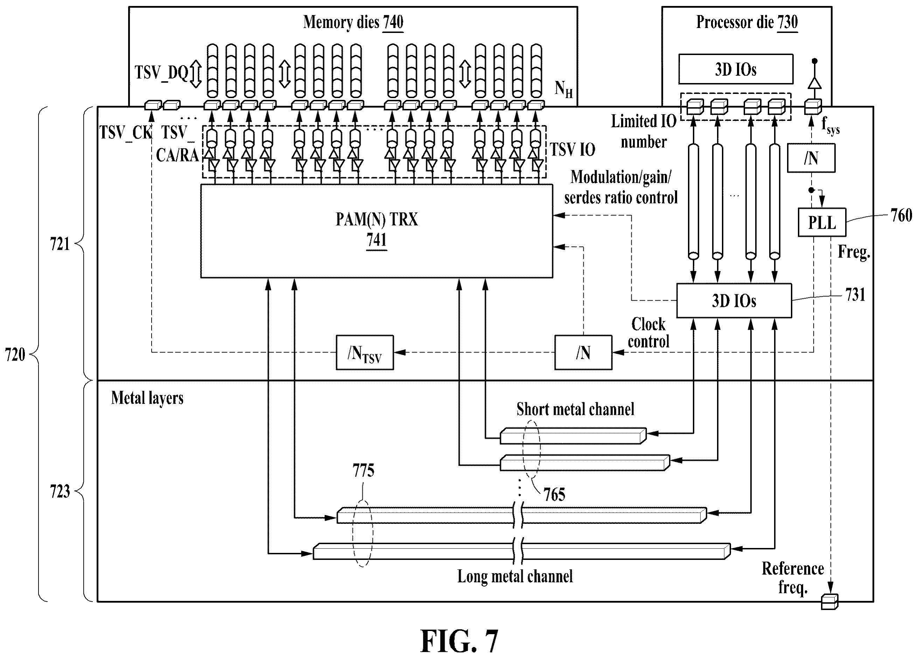

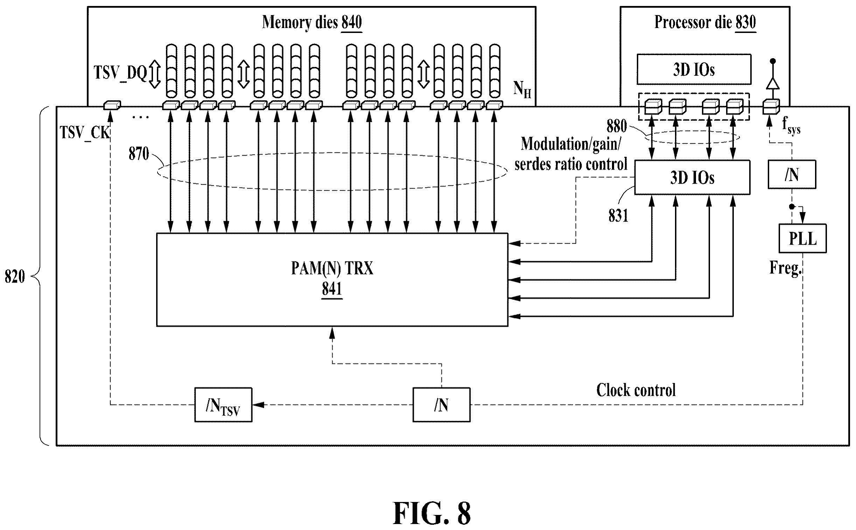

Referring to FIG. 4, data may be transferred between the processor die 430 and the first and second memory dies 440 and 450 via an active interconnect die 420. Through electrodes between the first and second memory dies 440 and 450 and respective TRXs 441 and 451 may include a plurality of data lines for transmitting data at a relatively low speed. Since a metal line for connecting each of the TRXs 441 and 451 to 3DIOs 431 is used as a channel, signal attenuation may increase as the distance of data transmission increases. To compensate for the metal channel loss, adaptive control of a modulation type, a SerDes ratio, and a gain may be applied to the TRXs 441 and 451 based on the loss or strength of the signal that the 3DIOs 431 receive. The adaptive control is further described with reference to FIGS. 7 and 8.

The 3DIOs 431 may perform equalizing to compensate for metal channel loss. A through electrode between the 3DIOs 431 and 3DIOs 433 in the processor die 430 may transmit data at a relatively high speed.

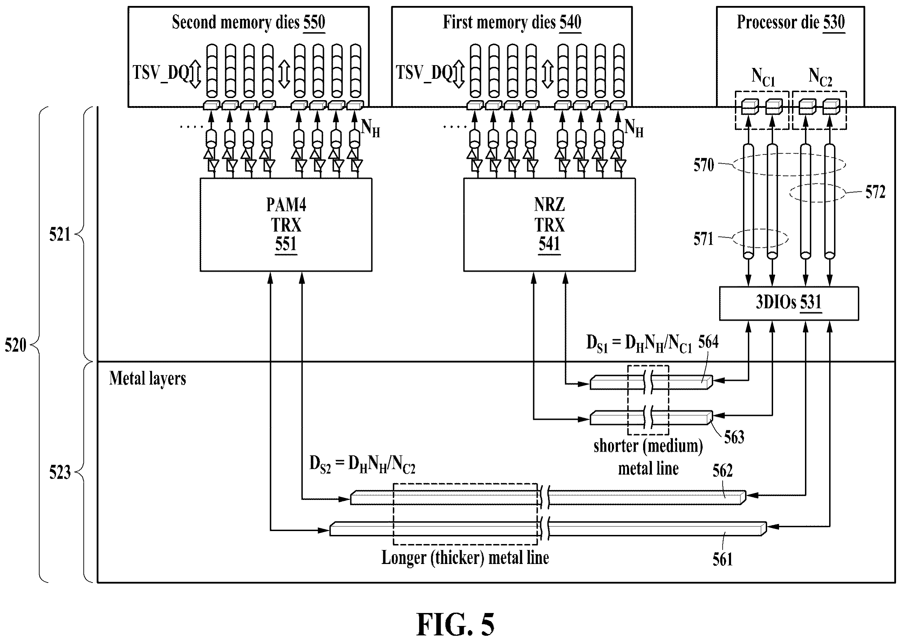

FIG. 5 is a diagram illustrating operations of an active interconnect die included in a semiconductor package according to one or more embodiments.

Referring to FIG. 5, various elements included in an active interconnect die 520 are illustrated as an example. The numbers of memory dies, processor dies, TRXs, and data lines shown in FIG. 5 are examples and are not limited thereto.

A TRX 541 that receives parallel data from short range first memory dies 540 via a TSV may convert the parallel data into serial data according to a first SerDes ratio and after modulating the serial data to non-return-to-zero (NRZ), may transmit the modulated data to the metal line. For example, the TRX 541 may convert the data at a higher frequency than a TSV IO and may transmit the data.

A TRX 551 that receives parallel data from far disposed second memory dies 550 via a TSV may convert the parallel data into serial data according to a second SerDes ratio and, after modulating the serial data to pulse-amplitude modulation 4 (PAM4), may transmit the modulated data to the metal line. For example, the TRX 551 may convert the data at a higher frequency than a TSV IO and may transmit the data.

Since channel losses are different according to a distance difference of metal lines through which the data is transmitted from the TRXs 541 and 551, the SerDes ratios or modulation types applied to the TRXs 541 and 551 may be different from each other. For example, a signal frequency may be determined by considering signal attenuation by a metal line channel in an interconnect that connects the two memory dies 540 and 550 to a processor die 530, where the two memory dies 540/550 have different data transmission distances. For example, as the characteristics of the metal line channel, PAM4 in which a Nyquist frequency of the data is low may be applied to the data transmission of the far second memory dies 550 and NRZ may be applied to the data transmission of the short range first memory dies 540. For example, since signal attenuation may significantly occur when a signal frequency increases in a long distance that is greater than or equal to 8000 um, the PAM4 modulation type may be selected.

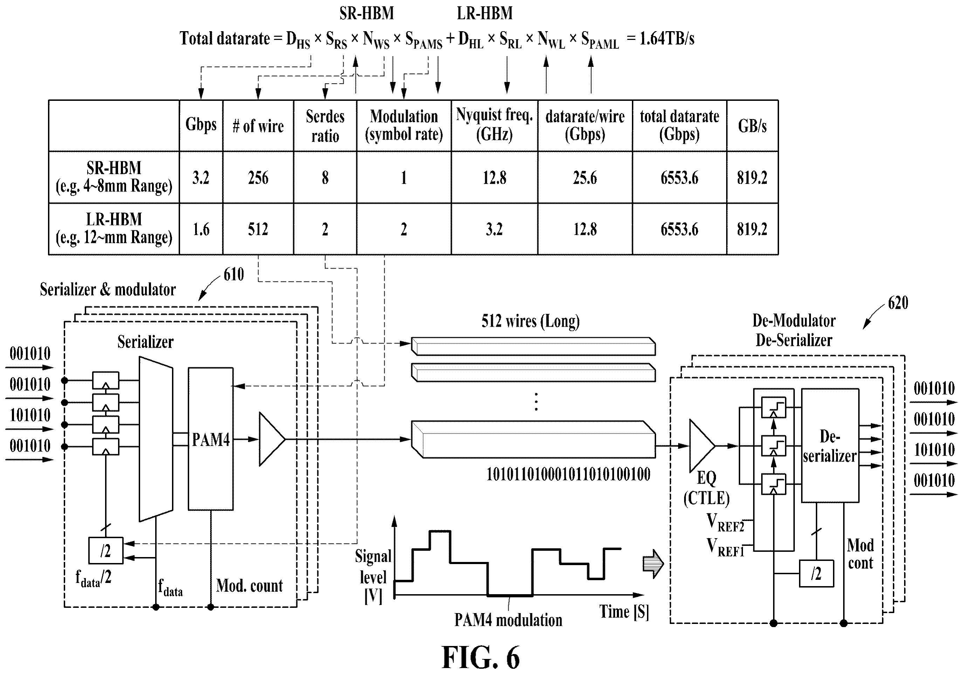

In addition, the thicknesses and/or numbers of metal lines connected to the TRXs 541 and 551 may be different from each other. Typically, as the thickness of the metal line increases, a resistance value may decrease, and thereby, the loss occurring during the data transmission may be reduced. Due to the characteristics, the metal line 561/562 connected to the TRX 551 that needs to transmit the data further may be thicker than the metal line 563/564 connected to the TRX 541. In other words, the thickness of a metal line arranged in a layer may increase as moving from the metal layer 523 to an upper silicon layer 521. However, the thicknesses of the metal lines are not limited thereto. Since the thickness needs to satisfy only the condition that the loss occurring in the metal line needs to be below a predetermined level, depending on the embodiments, the metal line 563/564 connected to the TRX 541 for transmitting the data in a short range may be designed to be as thick as the metal line 561/562 connected to the TRX 551 to minimize the data loss. The difference between the TRXs 541 and 551 is further described with reference to FIG. 6. For example, the thickness of the metal lines 561/562/563/564 may refer to the width and/or height of the corresponding metal lines, such as a "lateral thickness" for example.

The 3DIOs 531 may demodulate the data transmitted from the TRXs 541 and 551. The 3DIOs 531 may convert the demodulated data into parallel data and may transmit the parallel data to the processor die 530 through the TSV, as necessary. As shown in the example of FIG. 5, when transmitting the data received from two metal lines to two TSV data lines, the operation of converting the demodulated data into the parallel data in the 3DIOs 531 may not be performed. When transmitting the data to TSV data lines that are more than the number of metal lines, the operation of converting the demodulated data into the parallel data in the 3DIOs 531 may be performed.

The data lines 570 of the TSV connecting the 3DIOs 531 to the processor die 530 may be divided into a first line 571 (or set of first lines) for transmitting data of the first memory dies 540 and a second line 572 (or set of second lines) for transmitting data of the second memory dies 550. A ratio of first lines 571 to the second lines 572 of the data lines 570 of the TSV that connects the 3DIOs 531 to the processor die 530 may be considered for the architecture design of the semiconductor package. For example, data loss of the second memory dies 550 in a relatively long range may occur frequently and the data movement time may also take longer, the data lines of the TSV may be designed so that the number of second lines 572 is greater than the number of first lines 571. However, embodiments are not limited thereto. In FIG. 5, $N_{C1}$ may indicate the number of pins of the processor die 530 that receives the data of the first memory dies 540 and $N_{C2}$ may indicate the number of pins of the processor die 530 that receives the data of the second memory dies 550.

The data of multiple memory dies may need to be simultaneously transmitted to increase a data rate or the volume of data transmitted to the processor die 530, and when the numbers of pins connected to the processor die 530 are the same, a data rate per pin may increase to expand the bandwidth.

For example, when the volume of data transmitted from the second memory dies 550 to the TSV IO is A number of B Gbps and C pins of the processor die 530 are required, (A x B)/C Gbps of data may be transmitted per pin of the processor die 530 and a SerDes ratio may be determined to be A/C (e.g., when an operation of a de-serializer is not performed in the 3DIOs 531).

FIG. 6 is a diagram illustrating a total data rate of short range memory dies and long range memory dies according to one or more embodiments.

Referring to FIG. 6, serialization and modulation performed by a TRX 610 and deserialization and demodulation performed by 3DIOs 620 are illustrated as an example to describe a total data rate of short range memory dies and long range memory dies. In FIG. 6, short range-HBM (SR-HBM) may indicate short range memory dies and long range-HBM (LR-HBM) may indicate long range memory dies. The specific numerical values shown in FIG. 6 as an example are for ease of explanation and the numerical values applied to an actual semiconductor package are not limited thereto.

A total data rate of short range memory dies and long range memory dies may be expressed as Equation (1) below.

$$\text{Total Datarate} = D_{HS} \times S_{RS} \times N_{WS} \times S_{PAMS} + D_{HL} \times S_{RL} \times N_{WL} \times S_{PAML} \tag{1}$$

In Equation (1), $D_{HS}$ may denote a data rate for a TSV of short range memory dies, $S_{RS}$ may denote a SerDes ratio applied to a TRX connected to the short range memory dies, $N_{WS}$ may denote the number of metal lines for transmitting the data of the short range memory dies, and $S_{PAMS}$ may denote a modulation type applied to the TRX connected to the short range memory dies, in other words, a symbol rate. $D_{HL}$ may denote a data rate for a TSV of long range memory dies, $S_{RL}$ may denote a SerDes ratio applied to a TRX connected to the long range memory dies, $N_{WL}$ may denote the number of metal lines for transmitting the data of the long range memory dies, and $S_{PAML}$ may denote a modulation type applied to the TRX connected to the long range memory dies, in other words, a symbol rate.

In the example of FIG. 6, the SerDes ratio applied to the TRX 610 connected to the long range memory dies may be 2:1 and the modulation type applied to the TRX 610 may be PAM4 of which a symbol rate corresponds to 2. In other words, the TRX 610 may convert every two pieces of parallel data transmitted from the long range memory dies into one piece of serial data. As shown in FIG. 6, a serializer in the TRX 610 may receive four pieces of parallel data, may output two pieces of serial data, and may transmit the serial data to a modulator in the TRX 610. The modulator may modulate two pieces of serial data to PAM4 and may output one piece of modulated data. The above descriptions are to describe a ratio among parallel data, serial data, and modulated data. The actual number of parallel data pieces input to the TRX 610 may be more than four and the numbers of serial data pieces and modulated data pieces may be determined in proportion to the number of parallel data pieces. The modulated data may be transmitted to the 3DIOs 620 through 512 metal lines. The 3DIOs 620 may demodulate the received modulated data through the metal lines and may convert the demodulated data into parallel data. The symbol rate may indicate a degree of modulation of a signal and may also be referred to as a modulation index.

The SerDes ratio applied to a TRX connected to the short range memory dies may be 8:1 and the modulation type applied to the TRX connected to the short range memory dies may be NRZ of which a symbol rate corresponds to 1. In other words, the TRX connected to the short range memory dies may convert every eight pieces of parallel data transmitted from the short range memory dies into one piece of serial data, may modulate the serial data to NRZ, and may transmit the modulated data to 256 metal lines. The corresponding 3DIOs may demodulate the received data through the metal lines and may convert the demodulated data into the parallel data.

As described above, the number of metal lines for transmitting the data from the long range memory dies may be different from the number of metal lines for transmitting the data from the short range memory dies. For example, the number of metal lines for transmitting the data from the long range memory dies may be greater than the number of metal lines for transmitting the data from the short range memory dies.

The signal attenuation of a metal line channel according to a transmission distance of the data may be determined by a Nyquist frequency of a signal and a modulation type of the signal may be determined according to the channel characteristics in the Nyquist frequency. An effective data rate of the Nyquist frequency may be determined based on the signal attenuation of the metal line channel and as the transmission distance increases, the modulation type with a greater symbol rate may be applied. For example, as the transmission distance increases, a modulation type with a great symbol rate, such as NRZ (i.e., PAM2), PAM4, or PAM8 may be used.

When transmitting the data, the data of the long range memory dies may need to be transmitted further than the data of the short range memory dies, and for this, high-speed data conversion SerDes may be used.

The SerDes may be a comprehensive method of a serializer for converting parallel data into serial data and a deserializer for restoring the serial data to the parallel data. A semiconductor package may keep the high data transmission speed while reducing the number of data lines using a SerDes circuit (i.e., a serializer and a deserializer). The SerDes circuit may minimize the signal distortion or loss and may maximize the data transmission efficiency. As described above, the memory dies and the processor die may perform efficient bidirectional data transmission through the SerDes circuit.

The SerDes circuit and the modulator included in the TRX 610 may serve to increase a data rate per pin of the processor die and the data rate may be converted by the SerDes ratio.

The SerDes ratio may be determined as in Equation (2).

$$\text{The number of TSV IOs of the memory dies } N_H \text{ / The number of metal lines } N_W \qquad (2)$$

When the number of metal lines $N_W$ is the same as the number of pins of the processor die $N_C$ without an operation of the deserializer in the 3DIOs 620, the SerDes ratio may also be determined as in Equation (3).

$$\text{The number of TSV IOs of the memory dies } N_H \text{ / The number of pins of the processor die } N_C \qquad (3)$$

When designing a semiconductor package, a data rate in the TSV from the memory dies to the TRX 610, a data rate in the metal line from the TRX 610 to the 3DIOs 620, and a data rate in the TSV from the 3DIOs 620 to the processor die may be set to be the same.

The loss of the metal line channel may be effectively compensated and the stability and accuracy of a signal may be ensured by disposing the TRX 610 including the SerDes circuit near the memory dies and disposing the 3DIOs 620 including an equalizer near the processor die in the active interconnect die.

According to one or more embodiments, as the metal lines are used as transmission channels, the signal attenuation may be great in a long metal line, and thereby, the transmission speed may vary according to the distance to stably transmit a data signal. For example, the data of the long range memory dies may be transmitted at a relatively low speed and the data of the short range memory dies may be transmitted at a relatively high speed. In addition, to maintain the bandwidths of two memory dies with different data transmission speeds to be the same and optimize the bandwidth, the number of pins of the processor die for receiving data of the two memory dies may vary. For example, the number of pins of the processor die receiving the data of the long range memory dies may be greater than the number of pins of the processor die receiving the data of the short range memory dies.

FIG. 7 is a diagram for illustrating adaptive control applied to a TRX according to one or more embodiments.

Referring to FIG. 7, an embodiment in which the above-described short range memory dies and long range memory dies are implemented as the same memory dies 740 is illustrated. As the size of the memory dies 740 increases, a near area adjacent to a processor die 730 and a far area that is not adjacent to the processor die 730 may exist in the memory dies 740. A TRX 741 that receives data through a TSV from the memory dies 740 may also be implemented as one. The TRX 741 may transmit the data received from the near area to a short metal line 765 and may transmit the data received from the far area to a long metal line 775. The TRX 741 may apply SerDes ratios and/or modulation types that are respectively appropriate to the data received from the near area and the data received from the far area according to the signal attenuation characteristics of each metal line channel. In addition, the thickness/length and/or the number of metal lines may be determined based on the signal attenuation characteristics of each metal line channel.

According to one or more embodiments, since the metal line is used as a channel, signal attenuation may occur as the data moves along the metal line, and adaptive control may be performed in 3DIOs 731 to compensate for the signal attenuation. The 3DIOs 731 may adaptively control a modulation type, a SerDes ratio, and a gain performed by the TRX 741 based on the loss or strength of the received signal. For example, when a signal loss is great due to a lot of signal attenuations in the metal line, the 3DIOs 731 may instruct the TRX 741 to change a modulation type with an increased symbol rate than before (e.g., change from NRZ to PAM4). When the signal loss is great, the 3DIOs 731 may instruct the TRX 741 to increase a SerDes ratio than before. When the strength of the received signal is small due to a lot of signal attenuations in the metal line, the 3DIOs 731 may instruct the TRX 741 to amplify a gain than before. When the strength of the signal is sufficient compared to a predetermined criterion and the attenuation occurs less, the 3DIOs 731 may instruct the TRX 741 to change the modulation type with a reduced symbol rate, reduce the SerDes ratio, or reduce the gain.

A phase-locked loop (PLL) 760 may provide a clock signal to an active circuit in an active interconnect die 720. A frequency of the clock signal output by the PLL 760 may be divided into N, which is a predetermined number, and may be provided to the TRX 741, and may be additionally divided into $N_{TSV}$, which is a predetermined number, and may be provided to the TSV. In other words, the frequency of the clock signal provided to the TSV may be lower than the frequency of the clock signal provided to the SerDes circuit and the modulator included in the TRX 741. Since the TRX 741 may need to convert parallel data transmitted from the TSV IO into serial data according to the SerDes ratio and transmit the data, the operating speed of the TRX 741 may be faster than the operating speed of the TSV. In addition, the frequency of the clock signal output from the PLL 760 may be divided into the predetermined number N and may be provided to the processor die 730. FIG. 7 illustrates that the frequency of the clock signal output by the PLL 760 is divided into the same number N and is provided to the TRX 741 and the processor die 730, but the frequency may be divided into different numbers according to one or more embodiments.

The above descriptions of the adaptive control applied to the TRX 741 and operations of the PLL 760 may apply to an example in which large memory dies 740 is applied and may also apply to an example in which short range memory dies and long range memory dies are provided separately. The adaptive control may be applied to a TRX corresponding to the short range memory dies and a TRX corresponding to the long range memory dies. **In** addition, the frequency of the clock signal output by the PLL 760 may be divided into $N_1$ and $N_2$, which are predetermined numbers, and may be provided to the TRX corresponding to the short range memory dies and the TRX corresponding to the long range memory dies, respectively. In this case, $N_1$ and $N_2$ may be the same or different from each other depending on the embodiment.

According to one or more embodiments, an electrical connection between the memory dies 740 and the active interconnect die 720 may vary depending on a direction in which a wiring layer of the active interconnect die 720 is disposed. An active area of the active interconnect die 720 may be formed below a wafer surface in which active elements, such as a transistor, are disposed to perform data operation and processing. A wiring layer area (i.e., a BEOL area) formed thereon may include multiple layers of metal wiring and may serve to transmit a signal generated in the active area.

As shown in FIG. 7, when the wiring layer of the active interconnect die 720 is disposed at the bottom (i.e., face-to-back connection), the wiring layer area of the active interconnect die 720 may be disposed at a lower part and may not be directly connected to the memory dies 740. In this case, a through electrode (i.e., a TSV) in a silicon layer 721 may penetrate the active interconnect die 720 and may be connected to memory dies 740 in the upper part. A signal generated in the memory dies 740 may be transmitted to the wiring layer under the active interconnect die 720. The wiring layer may be referred to as a metal layer 723 or a BEOL area.

FIG. 8 is a diagram illustrating an active interconnect die of face-to-face connection according to one or more embodiments.

Referring to FIG. 8, when a wiring layer of an active interconnect die 820 is disposed at the top (i.e., face-to-face connection), a wiring layer area of the active interconnect die 820 may be disposed at an upper part and may directly contact a wiring layer area of memory dies 840 and may be connected thereto. A TRX 841 in the active interconnect die 820 may be connected to the memory dies 840 through a metal line (e.g., lines 870) without a TSV and 3DIOs 831 may also be connected to a processor die 830 through a metal line (e.g., lines 880) without a TSV. In this case, the active interconnect die 820 may form a through electrode at the bottom to be connected to the outside and may be connected to an external circuit. The above descriptions may apply to the connection among the active interconnect die 820, the processor die 830, and the memory dies 840.

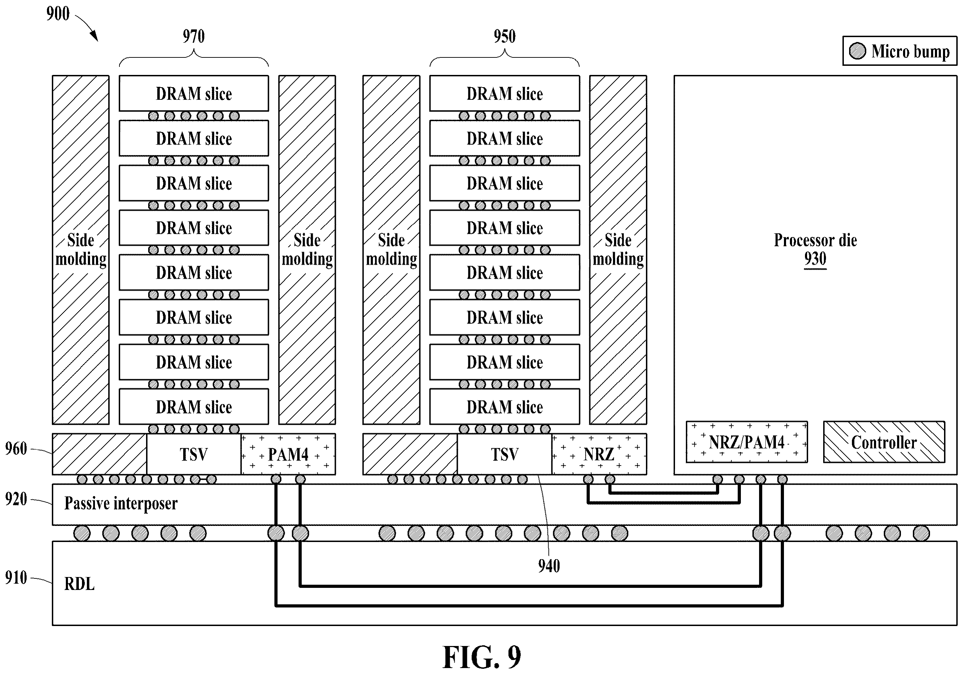

FIG. 9 is a diagram illustrating a semiconductor package structure to which a redistribution layer (RDL) is applied, according to one or more embodiments.

Referring to FIG. 9, a semiconductor package 900 may include an RDL 910, a passive interposer 920, a processor die 930, a first logic die 940, first memory dies 950, a second logic die 960, and second memory dies 970. The passive interposer 920 may be disposed on the RDL 910 and the processor die 930, the first logic die 940, and the second logic die 960 may be disposed on the passive interposer 920. The first memory dies 950 may be disposed on the first logic die 940 and the second memory dies 970 may be disposed on the second logic die 960. The first memory dies 950 may be disposed in a short range near the processor die 930 and the second memory dies 970 may be disposed in a long range far from the processor die 930. That is, the first memory dies 950 may be closer in proximity to the processor die 930 than the second memory dies 970.

The passive interposer 920 may be a passive element for providing an electrical connection and may provide a physical wiring path for communication between the first memory dies 950 and the processor die 930. In this case, the passive interposer 920 may serve to simply transmit an electrical signal and may not include any active circuit.

The first logic die 940 may play an important role in relaying data transmission between the first memory dies 950 and the processor die 930. The data stored in the first memory dies 950 may not be directly transmitted to the processor die 930 and may first be transmitted to the processor die 930 through the first logic die 940. In this process, the first logic die 940 may temporarily store a data signal and may transmit the signal by regenerating the signal to improve the stability and accuracy of the signal. In addition, the first logic die 940 may improve the data processing speed of the entire system by minimizing latency and signal distortion that may occur during the data transmission.

The presence of the first logic die 940 may be particularly important in a high-speed data transmission environment, because the signal loss and latency may increase as the physical distance between the first memory dies 950 and the processor die 930 increases. The first logic die 940 may alleviate the problem and may help smooth communication between the memory and the processor.

The description of the first logic die 940 may similarly apply to the second logic die 960. The logic die may also be referred to as a buffer die or a base die.

The first logic die 940 may convert parallel data received from the first memory dies 950 through a TSV into serial data at a predetermined SerDes ratio and may transmit the data to the processor die 930 through a data path included in the passive interposer 920 based on NRZ modulation.

As the second memory dies 970 are disposed in a long range far from the processor die 930, data transfer between the second memory dies 970 and the processor die 930 may be difficult through the data path included in the passive interposer 920 like the first memory dies 950. The data of the second memory dies 970 may be transmitted to the second logic die 960 through a TSV and the second logic die 960 may convert the received parallel data into serial data at a predetermined SerDes ratio and may modulate the serial data to PAM4. The modulated data may be transmitted through a metal line included in the RDL 910 through the passive interposer 920. The processor die 930 may receive the data transmitted through the metal line included in the RDL 910 through the passive interposer 920 again. The received data may be demodulated by a demodulator included in the processor die 930. For example, the demodulator included in the processor die 930 may be controlled by a controller.

Since the above descriptions may apply to operations of processing data of the memory dies 970 in a long range through a SerDes circuit and a modulator of the logic die 960 and transmitting the data to the processor die 930 through the metal line in the RDL 910, a detailed description thereof is omitted.

In the example of FIG. 9, micro bumps may be disposed between the RDL 910 and the passive interposer 920, between the passive interposer 920 and the processor die 930, between the passive interposer 920 and the first and second logic dies 940 and 960, and between the first and second logic dies 940 and 960 and the first and second memory dies 950 and 970 to electrically connect to each other. The micro bump may provide a contact between two layers and may ensure stable transmission of a data signal. For example, the micro bump may be provided as an example of a data pin and other types of data pins may be used. For example, other types of bumps, such as a copper (Cu) bump or a solder bump, may be used as a pin for data transmission. Alternatively, hybrid bonding for direct die-to-die connection may be used.

For ease of description, the data movement from the memory dies to the processor die is described. However, embodiments are not limited thereto and the above descriptions may apply to data movement from the processor die to the memory dies. In addition, the above descriptions with reference to FIGS. 1 to 9 may apply to various die-to-die data movements other than the data movement between the memory dies and the processor die.

The semiconductor package described herein may be included in various types of electronic devices. For example, the electronic device may include various computing devices, such as a mobile phone, a smartphone, a tablet personal computer (PC), an e-book device, a laptop, a PC, a desktop, a workstation, or a server, various wearable devices, such as a smartwatch, smart glasses, a head-mounted display (HMD), or smart clothes, various home appliances, such as a smart speaker, a smart television (TV), or a smart refrigerator, and a smart vehicle, a smart kiosk, an Internet of things (IoT) device, a walking assist device (WAD), a drone, or a robot.

The embodiments described herein may be implemented using a hardware component, a software component and/or a combination thereof. A processing device may be implemented using one or more general-purpose or special-purpose computers, such as, for example, a processor, a controller and an arithmetic logic unit (ALU), a DSP, a microcomputer, an FPGA, a programmable logic unit (PLU), a microprocessor or any other device capable of responding to and executing instructions in a defined manner. The processing device may run an operating system (OS) and one or more software applications that run on the OS. The processing device also may access, store, manipulate, process, and create data in response to execution of the software. For purpose of simplicity, the description of a processing device is used as singular; however, one skilled in the art will appreciate that a processing device may include multiple processing elements and multiple types of processing elements. For example, the processing device may include a plurality of processors, or a single processor and a single controller. In addition, different processing configurations are possible, such as parallel processors.

The software may include a computer program, a piece of code, an instruction, or some combination thereof, to independently or uniformly instruct or configure the processing device to operate as desired. Software and data may be stored in any type of machine, component, physical or virtual equipment, or computer storage medium or device capable of providing instructions or data to or being interpreted by the processing device. The software also may be distributed over network-coupled computer systems so that the software is stored and executed in a distributed fashion. The software and data may be stored by one or more non-transitory computer-readable recording mediums.

The methods according to the above-described embodiments may be recorded in non-transitory computer-readable media including program instructions to implement various operations of the above-described embodiments. The media may also include, alone or in combination with the program instructions, data files, data structures, and the like. The program instructions recorded on the media may be those specially designed and constructed for the purposes of example embodiments, or they may be of the kind well-known and available to those having skill in the computer software arts. Examples of non-transitory computer-readable media include magnetic media such as hard disks, floppy disks, and magnetic tape; optical media such as compact disc (CD) read-only memory (CD-ROM) discs, digital video discs (DVDs,) and/or blu-ray discs, magneto-optical media such as optical discs, and hardware devices that are specially configured to store and perform program instructions, such as ROM, random access memory (RAM), flash memory (e.g., universal serial bus (USB) flash drives, memory cards, memory sticks, etc.), and the like. Examples of program instructions include both machine code, such as produced by a compiler, and files containing higher-level code that may be executed by the computer using an interpreter.

The above-described hardware devices may be configured to act as one or more software modules in order to perform the operations of the above-described examples, or vice versa.

Each of the embodiments provided in the above description is not excluded from being associated with one or more features of another example or another embodiment also provided herein or not provided herein but consistent with the disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

For example, the present disclosure equally relates to a semiconductor package comprising an active interconnect die comprising a modulator and at least one first metal line, a processor die on the active interconnect die, first memory dies stacked on each other on the active interconnect die and spaced apart from the processor die by a first lateral distance, and second memory dies stacked on each other on the active interconnect die and spaced apart from the processor die by a second lateral. The at least one first metal line is configured for data communication between the second memory dies and the processor die. The active interconnect die further comprises at least one second metal line configured for the data communication between the first memory dies and the processor die.

In this embodiment, a SerDes ratio and/or a modulation type applied for the data communication between the second memory dies and the processor die is different depending on signal attenuation characteristics of a channel formed by the at least one first metal line, and/or a SerDes ratio and/or a modulation type applied for the data communication between the first memory dies and the processor die is different depending on signal attenuation characteristics of a channel formed by the at least one second metal line, wherein the signal attenuation characteristics preferably comprise at least one of signal attenuation, signal loss, received signal strength, and signal delay. In a particular embodiment, the SerDes ratio and/or the modulation type for the data communication between the first memory dies and the processor die is preferably different from the SerDes ratio and/or the modulation type for the data communication between the second memory dies and the processor die.

## Claims

1. A semiconductor package, comprising:

   an active interconnect die comprising a modulator and at least one first metal line;
   a processor die on the active interconnect die;
   first memory dies stacked on each other on the active interconnect die and spaced apart from the processor die by a first lateral distance; and
   second memory dies stacked on each other on the active interconnect die and spaced apart from the processor die by a second lateral distance that is greater than the first lateral distance;
   wherein the at least one first metal line is configured for data communication between the second memory dies and the processor die.

2. The semiconductor package of claim 1, wherein the active interconnect die comprises at least one second metal line configured for data communication between the first memory dies and the processor die.

3. The semiconductor package of claim 2, wherein the modulator comprises:

a first modulator configured to modulate data from the first memory dies that have been serialized and to transmit the modulated serial data to the at least one second metal line; and

a second modulator configured to modulate data from the second memory dies that have been serialized and to transmit the modulated serial data to the at least one first metal line.

4. The semiconductor package of claim 3, wherein the active die further comprises:

a first serializer configured to convert parallel data received from the first memory dies stacked on the active interconnect die into serial data based on a SerDes ratio;

a second serializer configured to convert parallel data received from the second memory dies stacked on the active interconnect die into serial data based on a SerDes ratio.

5. The semiconductor package of claim 3 or 4, wherein the active interconnect die comprises a three-dimensional input/output (3DIOs) configured to demodulate the modulated serial data received through the at least one metal line and the at least one second metal line and, to transmit the demodulated serial data to the processor die on the active interconnect die; or

wherein the processor comprises a three-dimensional input/output (3DIOs) configured to demodulate the modulated serial data received through the at least one metal line and the at least one second metal line die.

6. The semiconductor package of any of the previous claims, wherein a symbol rate of the data communication between the second memory dies and the processor die is greater than a symbol rate of a or the data communication between the first memory dies and the processor die; and/or

wherein a or the SerDes ratio of the data communication between the second memory dies and the processor die is less than a or the SerDes ratio of a or the data communication between the first memory dies and the processor die; and/or

wherein, in so far as depending on claim 2, a number of the at least one first metal line is different from a number of the at least one second metal line and/or wherein the at least one first metal line is thicker than the at least one second metal line.

7. The semiconductor package of any of the previous claims in so far as depending on claim 2, wherein a or the SerDes ratio and/or a modulation type applied for the data communication between the second memory dies and the processor die is different depending on signal attenuation characteristics of a channel formed by the at least one first metal line, and/or wherein a or the SerDes ratio and/or a modulation type applied for the data communication between the first memory dies and the processor die is different depending on signal attenuation characteristics of a channel formed by the at least one second metal line, wherein the signal attenuation characteristics preferably comprise at least one of signal attenuation, signal loss, received signal strength, and signal delay;

wherein the SerDes ratio and/or the modulation type for the data communication between the first memory dies and the processor die is preferably different from the SerDes ratio and/or the modulation type for the data communication between the second memory dies and the processor die.

8. The semiconductor package of any of the previous claims, wherein the processor die comprises a plurality of pins, and wherein a first number of pins of the plurality of pins of the processor die connected to the second memory dies is greater than a second number of pins of the plurality of pins of the processor die connected to the first memory dies; and/or

wherein the first memory dies are comprised in a first high bandwidth memory (HBM) and the second memory dies are comprised in a second HBM, or the first memory dies and the second memory dies are comprised in a same HBM.

9. The semiconductor package of any of the previous claims, wherein a or the modulation type of the data communication between the second memory dies and the processor die is controlled based on a loss of a signal transmitted through the at least one first metal line from the second memory dies; and/or

wherein a signal gain of the data communication between the second memory dies and the processor die is controlled based on a strength of a signal transmitted through the at least one first metal line from the second memory dies; and/or

wherein a frequency of a clock signal provided to a through silicon via (TSV) of at least one of the first memory dies and the second memory dies is lower than a frequency of a clock signal provided to the modulator.

**10.** An active interconnect die comprising:

a serializer configured to convert parallel data received from memory dies stacked on the active interconnect die into serial data based on a SerDes ratio;
a modulator configured to modulate the serial data and transmit the modulated serial data to at least one metal line; and
three-dimensional input/output (3DIOs) configured to demodulate the modulated serial data received through the at least one metal line and transmit the demodulated serial data to a processor die on the active interconnect die.

**11.** The active interconnect die of claim 10, wherein at least one of the SerDes ratio or a modulation type of the serial data are determined based on a lateral distance between the memory dies and the processor die.

**12.** The active interconnect die of claim 10 or 11, wherein at least one of a number of the at least one metal line or a thickness of the at least one metal line is determined based on a lateral distance between the memory dies and the processor die.

**13.** The active interconnect die of any of the claims 10-12, wherein the processor die comprises a number of pins, and wherein the number of pins of the processor die that are connected to the 3DIOs is determined based on a lateral distance between the memory dies and the processor die, and/or wherein the memory dies are comprised in a high bandwidth memory (HBM).

**14.** The active interconnect die of any of the claims 10-13, wherein a modulation type of the serial data is controlled based on a loss of a signal received by the 3DIOs through the at least one metal line; and/or

wherein a signal gain transmitted through the at least one metal line is controlled based on a strength of a signal received by the 3DIOs through the at least one metal line; and/or
wherein a frequency of a clock signal provided to a through silicon via (TSV) of the memory dies is lower than a frequency of a clock signal of the modulator.

**15.** A semiconductor package, comprising:

an interposer;
a logic die on the interposer, the logic die comprising a modulator;
memory dies stacked on the logic die and connected to the logic die via a through electrode;
a processor die on the interposer; and
a redistribution layer (RDL) below the interposer, the RDL comprising at least one metal line,
wherein the modulator and the at least one metal line are configured for data communication between the memory dies and the processor die;
wherein the modulator is preferably configured to modulate data received from the memory dies, and wherein the modulated data is preferably transmitted to the processor die by sequentially passing through the interposer, the at least one metal line in the RDL, and the interposer.

**FIG. 1**

**FIG. 2**

300

350

340

| Memory die |  | | Memory die |  |
| Memory die |  | 353 | Memory die |  | 343 |
| Memory die |  | | Memory die |  |
| Memory die |  | | Memory die |  |

Processor die 330

3DIOs 333

335

| TRX 351 | | TRX 341 | | 3DIOs 331 |

321

320

327

326

323

Substrate

325

# FIG. 3

FIG. 4

**FIG. 5**

EP 4 752 881 A2

SR-HBM          LR-HBM

$$\text{Total datarate} = D_{HS} \times S_{RS} \times N_{WS} \times S_{PAMS} + D_{HL} \times S_{RL} \times N_{WL} \times S_{PAML} = 1.64\text{TB/s}$$

| | Gbps | # of wire | Serdes ratio | Modulation (symbol rate) | Nyquist freq. (GHz) | datarate/wire (Gbps) | total datarate (Gbps) | GB/s |
|---|---|---|---|---|---|---|---|---|
| SR-HBM (e.g. 4~8mm Range) | 3.2 | 256 | 8 | 1 | 12.8 | 25.6 | 6553.6 | 819.2 |
| LR-HBM (e.g. 12~mm Range) | 1.6 | 512 | 2 | 2 | 3.2 | 12.8 | 6553.6 | 819.2 |

Serializer & modulator          610

Serializer

001010
001010
101010
001010

PAM4

$f_{data}/2$    /2

$f_{data}$    Mod. count

512 wires (Long)

101011010001011010100100

De-Modulator De-Serializer          620

EQ (CTLE)

$V_{REF2}$
$V_{REF1}$

De-serializer

Mod cont

/2

001010
001010
101010
001010

Signal level [V]

PAM4 modulation

Time [S]

**FIG. 6**

**FIG. 7**

EP 4 752 881 A2

Processor die 830

3D IOs

$f_{sys}$

/N

PLL

Freq.

3D IOs

831

880

Modulation/gain/
serdes ratio control

Memory dies 840

$N_H$

TSV_DQ

870

TSV_CK

PAM(N) TRX
841

/N

Clock control

$/N_{TSV}$

820

**FIG. 8**

FIG. 9